(19) Europäisches Patentamt
European Patent Office
Office européen des brevets

(11) **EP 4 636 426 B1**

(12) **EUROPEAN PATENT SPECIFICATION**

(45) Date of publication and mention
of the grant of the patent:
**17.06.2026 Bulletin 2026/25**

(21) Application number: **25169125.9**

(22) Date of filing: **08.04.2025**

(51) International Patent Classification (IPC):
**G01R 31/64** *(2020.01)*

(52) Cooperative Patent Classification (CPC):
**G01R 31/64**

(54) **MONITORING HEALTH OF CAPACITOR OF POWER CONVERTER**

ÜBERWACHUNG DES ZUSTANDS EINES KONDENSATORS EINES STROMWANDLERS

SURVEILLANCE DE L'ÉTAT D'UN CONDENSATEUR D'UN CONVERTISSEUR DE PUISSANCE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **19.04.2024 GB 202405505**

(43) Date of publication of application:
**22.10.2025 Bulletin 2025/43**

(73) Proprietor: **Rolls-Royce Deutschland Ltd & Co KG
15827 Blankenfelde-Mahlow (DE)**

(72) Inventors:
• **NADARAJAN, Sivakumar
15827 Blankenfelde-Mahlow (DE)**
• **VAIYAPURI, Viswanathan
15827 Blankenfelde-Mahlow (DE)**
• **MOHAMED HALICK, Mohamed Sathik
15827 Blankenfelde-Mahlow (DE)**

(56) References cited:
• **SUNDARARAJAN PRASANTH ET AL: "Condition
Monitoring of DC-Link Capacitors Using Goertzel
Algorithm for Failure Precursor Parameter and
Temperature Estimation", IEEE TRANSACTIONS
ON POWER ELECTRONICS, INSTITUTE OF
ELECTRICAL AND ELECTRONICS ENGINEERS,
USA, vol. 35, no. 6, 6 November 2019
(2019-11-06), pages 6386 - 6396, XP011774624,
ISSN: 0885-8993, [retrieved on 20200225], DOI:
10.1109/TPEL.2019.2951859**
• **RODRIGUES LEONARDO ACOSTA ET AL: "Real
Time Measurements of Aluminum Electrolytic
Capacitor Parameters in EVs Inverters", 2023
IEEE ENERGY CONVERSION CONGRESS AND
EXPOSITION (ECCE), IEEE, 29 October 2023
(2023-10-29), pages 3495 - 3502, XP034507898,
DOI: 10.1109/ECCE53617.2023.10362689**

Remarks:
The file contains technical information submitted
after the application was filed and not included in this
specification

**Description**

**FIELD**

The present disclosure relates to a method for monitoring a health of a capacitor of a power converter.

**BACKGROUND**

Electrical devices, such as, power converters are used in a multitude of applications where an efficient management and transformation of electrical energy is required. The power converters may be employed where an alternating current is the primary mode of power delivery, such as in renewable energy integration, vehicular propulsion, and various industrial processes. Despite their role, the power converters may also be susceptible to operational disruptions due to component degradation, which can lead to significant downtime and maintenance costs. The component degradation often stems from thermal and electrical stress.

One of the weakest components in a power converter system may be capacitors. Failures of the capacitors may be prevented by employing a suitable capacitor condition monitoring system to identify and predict capacitor degradation to estimate a remaining useful life of the capacitors.

Efforts to enhance reliability in the power converters have led to development of diagnostic tools aimed at assessing the health of the capacitors. However, current methods require additional hardware or modification in the existing hardware. Therefore, the current methods may not be suitable for commercial off-the-shelf power converters and may limit adaptability across different technologies prevalent in the field.

A method capable of estimating a condition of the capacitors without any additional hardware or modifications to existing hardware may offer substantial advantages in applications where safety and reliability are of high importance.

For capacitors, equivalent series resistance (ESR) and capacitance are the widely used degradation indicators where ESR is most commonly used for aluminium electrolytic, and capacitance is used for both aluminium electrolytic, film and ceramic types. Most of the existing methods focuses on only one of these two parameters. A background art is given by Sundararajan Prasanth et al., "Condition Monitoring of DC-Link Capacitors Using Goertzel Algorithm for Failure Precursor Parameter and Temperature Estimation", IEEE TRANSACTIONS ON POWER ELECTRONICS, INSTITUTE OF ELECTRICAL AND ELECTRONICS ENGINEERS, USA, vol. 35, no. 6, June 2020, pages 6386-6396.

Therefore, the industry recognizes the importance of a versatile and integrated approach to health monitoring of the capacitors of the power converters that can operate with existing system configurations and provide comprehensive diagnostics.

There is a need to provide a method for monitoring a health of a capacitor of a power converter that addresses the aforementioned shortcomings or at least provides a useful alternative to known such methods.

**SUMMARY**

In accordance with a first aspect of the present disclosure, a method for monitoring a health of a capacitor of a power converter is disclosed. The method comprises acquiring a DC link capacitor voltage $V_{dc}$, an input current $I_{in}$, phase currents $I_a$, $I_b$, $I_c$, and switching pulses SP1, SP2, SP3 of the power converter. The method further comprises calculating a DC link current $I_{dc}$ based on the switching pulses SP1, SP2, SP3 and the phase currents $I_a$, $I_b$, $I_c$. The method further comprises calculating a capacitor current $I_{cap}$ based on the DC link current $I_{dc}$ and the input current $I_{in}$. The method further comprises applying Goertzel algorithm to determine a first z-domain equation $H(z)I_{cap}$ of the capacitor current $I_{cap}$ and a second z-domain equation $H(z)V_{dc}$ of the DC link capacitor voltage $V_{dc}$. The method further comprises determining an estimated equivalent series resistance (ESR) and an estimated capacitance of the capacitor based on the first z-domain equation $H(z)I_{cap}$ of the capacitor current $I_{cap}$ and the second z-domain equation $H(z)V_{dc}$ of the DC link capacitor voltage $V_{dc}$. The method further comprises retrieving an initial ESR and an initial capacitance of the capacitor. The method further comprises comparing the estimated ESR with the initial ESR and/or the estimated capacitance with the initial capacitance to determine if the capacitor is degraded, short-circuited, or open-circuited.

The method according to the present disclosure may enable equipment health monitoring (EHM) and remaining useful life estimation of the capacitor in the power converter. The method may be applied to existing power converters just by accessing terminals that are usually available for a user by acquiring the DC link capacitor voltage $V_{dc}$, the input current $I_{in}$, the phase currents $I_a$, $I_b$, $I_c$, and the switching pulses SP1, SP2, SP3 of the power converter. These parameters may be easy to obtain using available data and using inexpensive sensors and may not require any customized circuits to extract any signature. Therefore, the method may be easily applied to any commercial off-the-shelf as well as in-house power converter systems. The method may further provide an early detection of degradation, short-circuits, or open-circuits, which further may enable to prevent the power converter failures. The method may therefore reduce maintenance costs. Further, the method uses the estimated capacitance and the estimated ESR and therefore may be applied to dominant capacitor technologies.

Further developments of the method can be found in the dependent claims and show particularly advantageous possibilities to realize above-described concept in light of the object of the disclosure and regarding further advantages.

In a further development, the method comprises pausing an operation of the power converter upon determining that the capacitor is degraded, short-circuited, or open-circuited.

Pausing the operation of the power converter upon determining that the capacitor is degraded, short-circuit, or open-circuit may prevent any occurrence of damage to the power converter and/or a load electrically connected to the power converter.

In a further development, the DC link capacitor voltage is acquired from a voltage sensor. The voltage sensor used to acquire the DC link capacitor voltage may be an inexpensive voltage sensor.

In a further development, the input current is acquired from an input current sensor. The input current sensor used to acquire the input current may be an inexpensive current sensor.

In a further development, the phase currents are acquired from corresponding phase current sensors. The phase current sensors used to acquire the phase currents may be inexpensive current sensors.

In a further development, the switching pulses are acquired from a controller of the power converter. The switching pulses may be readily and easily acquired from the controller of the power converter.

In a further development, the DC link current is calculated from the equation:

$$I_{dc} = SP1 * I_a + SP2 * I_b + SP3 * I_c$$

Therefore, the DC link current may be simply calculated using the switching pulses and the phase currents which may be acquired using inexpensive current sensors.

In a further development, the capacitor current is calculated by subtracting the DC link current from the input current.

Therefore, the capacitor current may be easily determined in a simplified manner without any additional components or modifications by employing inexpensive current and voltage sensors.

In a further development, the first z-domain equation of the capacitor current is:

$$H(z)Icap = \frac{1 - w^{kx}NxZ^{-1}}{1 - 2\cos\left(\frac{2\pi kx}{Nx}\right)Z^{-1} + Z^{-2}} * Icap$$

Where, Nx is a number of samples and Kx is:

$$Kx = \frac{Nx}{1/_{Nx*Ts}}$$

where, Ts is a sampling time.

The first z-domain equation may provide efficient evaluation of the capacitor current.

In a further development, the second z-domain equation of the DC link capacitor voltage is:

$$H(z)Vdc = \frac{1 - w^{kx}NxZ^{-1}}{1 - 2\cos\left(\frac{2\pi kx}{Nx}\right)Z^{-1} + Z^{-2}} * Vdc$$

where, Nx is the number of samples and kx is,

$$Kx = \frac{Nx}{1/_{Nx*Ts}}$$

where, Ts is the sampling time.

The second z-domain equation may provide efficient evaluation of the capacitor voltage.

In a further development, the estimated ESR of the capacitor is estimated from the equation:

$$\text{estimated ESR} = \text{Real}(\frac{H(z)Vdc}{H(z)Icap})$$

The estimated ESR may be simply and accurately estimated using the first and second z-domain equations from the above equation.

In a further development, the method comprises identifying a dominant frequency component based on the DC link capacitor voltage.

The dominant frequency component may be used to estimate the estimated capacitance of the capacitor.

In a further development, the estimated capacitance of the capacitor is estimated from the equation:

$$\text{estimated capacitance} = \text{Imag}\left(\frac{H(z)Vdc}{H(z)Icap}\right) * abs(1/(2 * pi * fd))$$

The estimated capacitance may be simply and accurately estimated using the first and second z-domain equations from the above equation.

In a further development, the method comprises indicating that the capacitor is degraded if the estimated ESR is greater than the initial ESR by at least 10% of the initial ESR.

Upon receiving an indication that the capacitor is degraded, a user or a controller may decide the subsequent steps (e.g., to pause or stop an operation of the power converter) accordingly.

In a further development, the method comprises indicating that the capacitor is short-circuited if the estimated ESR is less than the initial ESR by at least 100% of the initial ESR.

Upon receiving an indication that the capacitor is short-circuited, the user or the controller may decide the subsequent steps (e.g., to pause or stop the operation of the power converter) accordingly.

In a further development, the method comprises indicating that the capacitor is degraded if the estimated capacitance is less than the initial capacitance by at least 5% of the initial capacitance and at most 50% of the initial capacitance.

Upon receiving an indication that the capacitor is degraded, the user or the controller may decide the subsequent steps (e.g., to pause or stop the operation of the power converter) accordingly.

In a further development, the method comprises indicating that the capacitor is open-circuited if the estimated capacitance is less than the initial capacitance by at least 50% of the initial capacitance.

Upon receiving an indication that the capacitor is open-circuited, the user or the controller may decide the subsequent steps (e.g., to pause or stop the operation of the power converter) accordingly.

According to a second aspect, a system is disclosed. The system comprises a processor and a memory having stored therein a plurality of instructions that when executed by the processor causes the system to perform the method of the first aspect.

It shall be understood that the method for monitoring the health of the capacitor of the power converter according to the first aspect of the disclosure and the system according to the second aspect of the disclosure may comprise identical or similar developments, in particular as described in the dependent claims. Therefore, a development of one aspect of the disclosure is also applicable to another aspect of the disclosure.

These and other aspects of the method of the present disclosure will be apparent from and elucidated with reference to the embodiments described hereinafter. The embodiments of the method are described in the following on the basis of the drawings. The latter is not necessarily intended to represent the embodiments to scale. Drawings are, where useful for explanation, shown in schematized and/or slightly distorted form. With regard to additions to the teachings immediately recognizable from the drawings, reference is made to the relevant state-of-the-art. It should be borne in mind that numerous modifications and changes can be made to the form and detail of an embodiment without deviating from the general idea of the disclosure. The features of the method of the present disclosure in the description, in the drawings and in the claims may be essential for a further development of the method either individually or in any combination.

In addition, all combinations of at least two of the features disclosed in the description, drawings and/or claims fall within the scope of the disclosure. The general idea of the disclosure is not limited to the exact form or detail of the preferred embodiment shown and described below, or to an object which would be limited in comparison to the object claimed in the claims. For specified design ranges, values within the specified limits are also disclosed as limit values and thus arbitrarily applicable and claimable.

## BRIEF DESCRIPTION OF THE DRAWINGS

Further advantages, features and details of the present disclosure result from the following description of the preferred embodiments as well as from the drawings, which show in:

FIG. 1    a schematic circuit diagram of a power converter, according to an embodiment of the present disclosure;

FIG. 2    a schematic block diagram of a system, according to an embodiment of the present disclosure;

FIG. 3    a flow chart for a method for monitoring a health of a capacitor of the power converter, according to an embodiment of the present disclosure;

FIG. 4    an exemplary graphical representation of current phases;

FIG. 5    an exemplary graphical representation of an input current, a DC link current and a DC link current;

FIG. 6    an exemplary graph depicting an amplitude versus a frequency of a DC link capacitor voltage;

FIG. 7    a flow chart of a method for determining an estimated equivalent series resistance (ESR) of the capacitor, according to an embodiment of the present disclosure; and

FIG. 8    a flow chart of a method for determining an estimated capacitance of the capacitor, according to an embodiment of the present disclosure.

## DETAILED DESCRIPTION

Aspects and embodiments of the present disclosure will now be discussed with reference to the accompanying figures. Further aspects and embodiments will be apparent to those skilled in the art.

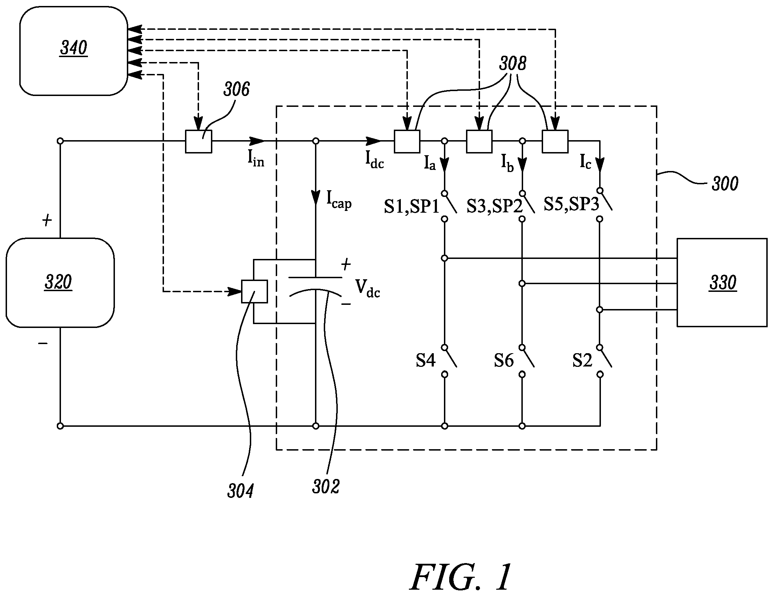

FIG. 1 shows a schematic circuit diagram of a power converter 300, according to an embodiment of the present disclosure. In the illustrated embodiment of FIG. 1, the power converter 300 is a three-phase inverter. Further, the power converter 300 may be a commercial off-the-shelf power converter.

The power converter 300 comprises a plurality of switches S1, S2, S3, S4, S5, S6. In the illustrated example of FIG. 1, the power converter 300 comprises six switches. However, in some other embodiments, the power converter 300 may comprise any number of switches based on desired application attributes. The power converter 300 further comprises a capacitor 302 electrically connected in parallel with the plurality of switches S1, S2, S3, S4, S5, S6. In some embodiments, the capacitor 302 is a DC link capacitor. In some embodiments, the capacitor 302 may provide energy for one switching cycle of the power converter 300.

In the illustrated example of FIG. 1, the power converter 300 is electrically connected to a DC source 320. The DC source 320 is configured to provide a DC power to the power converter 300. In some embodiments, the DC source 320 may be a rectifier. In some embodiments, the DC source 320 may be a battery. Further, the power converter 300 is electrically connected to a load 330. In some embodiments, the load 330 may be a three-phase motor.

In some cases, the DC source 320 may introduce parasitic inductance in the power converter 300. When the DC source 320 is the rectifier, the DC source 320 may introduce its own harmonics into the power converter 300. In such cases, the capacitor 302 may be used to eliminate the harmonics and provide a fundamental component to the power converter 300. Hence, the capacitor 302 may play an important role in the operation of the power converter 300.

As shown in FIG. 1, the DC source 320 provides an input current $I_{in}$ to the power converter 300. Further, an electrical voltage across the capacitor 302 is a DC link capacitor voltage $V_{dc}$. Furthermore, each phase of the power converter 300 receives a corresponding phase current $I_a$, $I_b$, $I_c$. Specifically, the phase of the power converter 300 comprising the switches S1, S4 receives the phase current $I_a$, the phase of the power converter 300 comprising the switches S3, S6 receives the phase current $I_b$, and the phase of the power converter 300 comprising the switches S5, S2 receives the phase current $I_c$. Furthermore, each phase of the power converter 300 receives a corresponding switching pulse SP1, SP2, SP3. Specifically, the phase of the power converter 300 comprising the switches S1, S4 receives the switching pulse SP1, the phase of the power converter 300 comprising the switches S3, S6 receives the switching pulse SP2, and the phase of the power converter 300 comprising the switches S5, S2 receives the switching pulse SP3. In some embodiments, the switching pulses SP1, SP2, SP3 may be provided by a controller 340. In some embodiments, the controller 340 may be a component of the power converter 300. In some embodiments, the power converter 300 may operate using a typical pulse width modulation (PWM) technique. Switching of the power converter 300 may produce a current which has a fundamental component and many harmonics. Both the fundamental and harmonic currents are drawn from the capacitor 302.

In some embodiments, the DC link capacitor voltage $V_{dc}$ is acquired from a voltage sensor 304. Further, in some embodiments, the input current $I_{in}$ is acquired from an input current sensor 306. In some embodiments, the phase currents $I_a$, $I_b$, $I_c$ are acquired from corresponding phase current sensors 308. In some embodiments, the switching pulses SP1, SP2, SP3 are acquired from the controller 340 of the power converter 300.

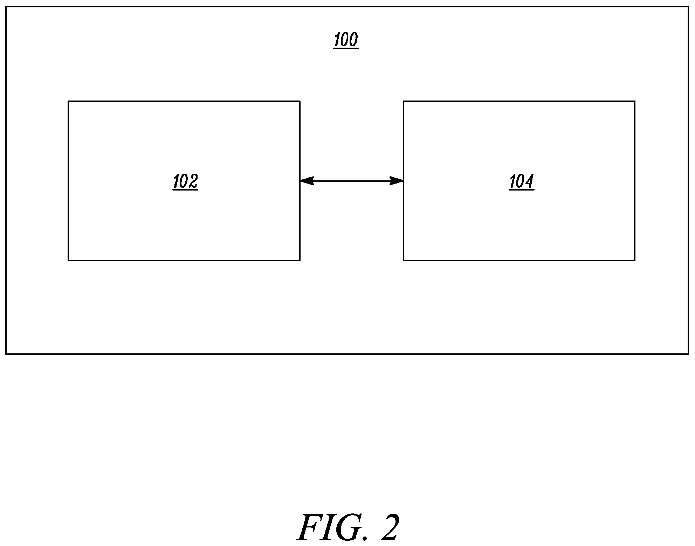

FIG. 2 shows a schematic block diagram of a system 100, according to an embodiment of the present disclosure. The system 100 comprises a processor 102 and a memory 104 having stored therein a plurality of instructions that when executed by the processor 102 causes the system 100 to perform operations described herein.

Referring to FIGS. 1 and 2, in some embodiments, the processor 102 is communicably connected to the input current sensor 306, the voltage sensor 304, and the phase current sensors 308. The processor 102 may monitor the health of the capacitor 302 of the power converter 300 by performing the operations described herein.

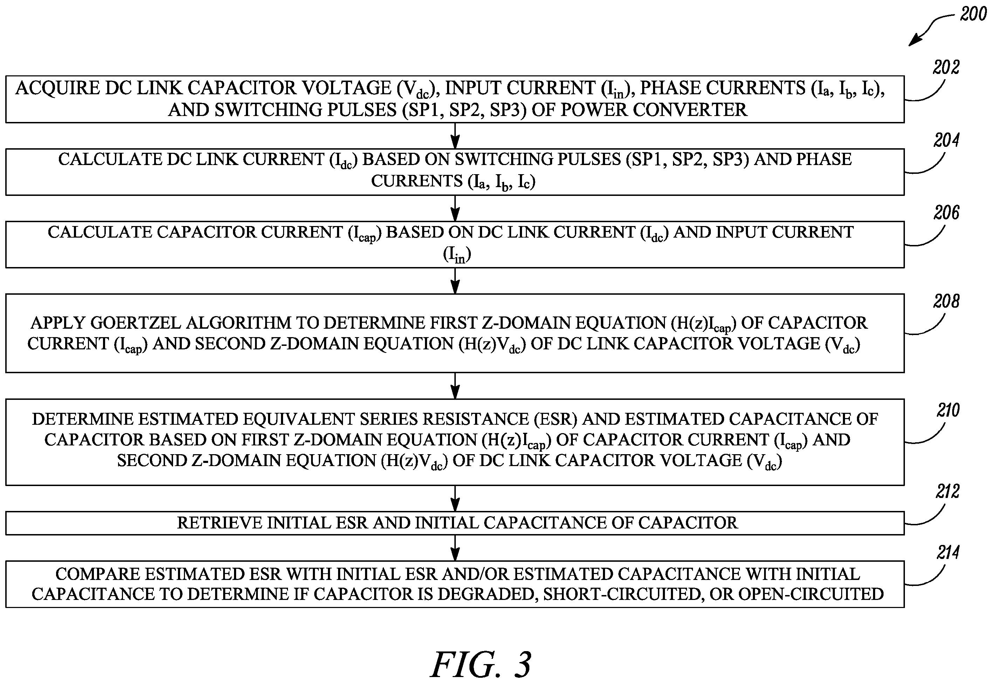

FIG. 3 shows a flow chart for a method 200 for monitoring the health of the capacitor 302 of the power converter 300 shown in FIG. 1, according to an embodiment of the present disclosure. The method 200 is described with further reference to FIGS. 1 and 2. In some embodiments, the processor 102 causes the system 100 to perform the method 200.

At step 202, the method 200 comprises acquiring the DC link capacitor voltage $V_{dc}$, the input current $I_{in}$, the phase currents $I_a$, $I_b$, $I_c$, and the switching pulses SP1, SP2, SP3 of the power converter 300.

As discussed above, in some embodiments, the DC link capacitor voltage $V_{dc}$ is acquired from the voltage sensor 304, the input current $I_{in}$ is acquired from the input current sensor 306, the phase currents $I_a$, $I_b$, $I_c$ are acquired from the corresponding phase current sensors 308, and the switching pulses SP1, SP2, SP3 are acquired from the controller 340 of the power converter 300.

At step 204, the method 200 comprises calculating a DC link current $I_d$, based on the switching pulses SP1, SP2, SP3 and the phase currents $I_a$, $I_b$, $I_c$. In some embodiments, the DC link current $I_d$, is calculated from the equation:

$$I_{dc} = SP1 * I_a + SP2 * I_b + SP3 * I_c.$$

At step 206, the method 200 comprises calculating a capacitor current $I_{cap}$ based on the DC link current $I_{dc}$ and the input current $I_{in}$. In some embodiments, the capacitor current $I_{cap}$ is calculated by subtracting the DC link current $I_{dc}$ from the input current $I_{in}$, i.e., $I_{cap} = I_{in} - I_{dc}$. The capacitor current $I_{cap}$ may produce a variation in the DC link voltage $V_{dc}$.

Therefore, the capacitor current $I_{cap}$ may be easily determined using the method 200 by employing the input current sensor 306 and the phase current sensors 308. The input current sensor 306 and the phase current sensors 308 may be less expensive compared to high-bandwidth current sensors that may be required for capacitor current sensing applications.

At step 208, the method 200 comprises applying Goertzel algorithm to determine a first z-domain equation $H(z)I_{cap}$ of the capacitor current $I_{cap}$ and a second z-domain equation $H(z)V_{dc}$ of the DC link capacitor voltage $V_{dc}$.

In some embodiments, the first z-domain equation $H(z)I_{cap}$ of the capacitor current $I_{cap}$ is:

$$H(z)Icap = \frac{1 - w^{kx}NxZ^{-1}}{1 - 2\cos\left(\frac{2\pi kx}{Nx}\right)Z^{-1} + Z^{-2}} * Icap$$

where, Nx is a number of samples and Kx is:

$$Kx = \frac{Nx}{1/_{Nx*Ts}}$$

where, Ts is a sampling time.

In some embodiments, the number of samples Nx and the sampling time Ts may be based on a switching frequency of the power converter 300.

Further, in some embodiments, the second z-domain equation $H(z)V_{dc}$ of the DC link capacitor voltage $V_{dc}$ is:

$$H(z)Vdc = \frac{1 - w^{kx}NxZ^{-1}}{1 - 2\cos\left(\frac{2\pi kx}{Nx}\right)Z^{-1} + Z^{-2}} * Vdc$$

At step 210, the method 200 comprises determining an estimated equivalent series resistance (ESR) and an estimated capacitance of the capacitor 302 based on the first z-domain equation $H(z)I_{cap}$ of the capacitor current $I_{cap}$ and the second z-domain equation $H(z)V_{dc}$ of the DC link capacitor voltage $V_{dc}$.

In some embodiments, the estimated ESR of the capacitor 302 is estimated from the equation:

$$\text{estimated ESR} = \text{Real}\left(\frac{H(z)Vdc}{H(z)Icap}\right)$$

Furthermore, in some embodiments, the estimated capacitance of the capacitor 302 is estimated from the equation:

EP 4 636 426 B1

$$\text{estimated capacitance} = \text{Imag}\left(\frac{H(z)Vdc}{H(z)Icap}\right) * \text{abs}(1/(2 * \text{pi} * \text{fd}))$$

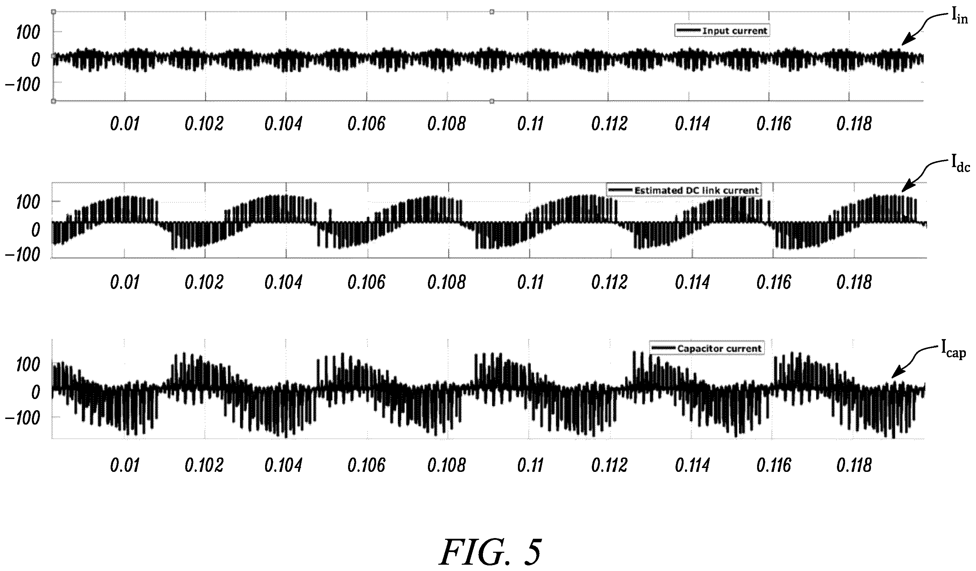

where, fd is a dominant frequency component (shown in FIG. 5).

In some embodiments, the method 200 further comprises identifying the dominant frequency component fd based on the DC link capacitor voltage $V_{dc}$. In some embodiments, the dominant frequency component fd is about $\pm 5\%$ of the switching frequency of the power converter 300.

Therefore, the method 200 may rely on measuring the switching current harmonics to estimate the estimate capacitance and the estimate ESR.

At step 212, the method 200 comprises retrieving an initial ESR and an initial capacitance of the capacitor 302. In some embodiments, the initial ESR and the initial capacitance of the capacitor 302 may be retrieved from the memory 104 communicably coupled to the processor 102. In some other embodiments, the initial ESR and the initial capacitance of the capacitor 302 may be retrieved from an external database (not shown) communicably coupled to the processor 102.

At step 214, the method 200 comprises comparing the estimated ESR with the initial ESR and/or the estimated capacitance with the initial capacitance to determine if the capacitor 302 is degraded, short-circuited, or open-circuited. In some embodiments, the method 200 comprises pausing an operation of the power converter 300 upon determining that the capacitor 302 is degraded, short-circuited, or open-circuited. In some embodiments, the method 200 comprises stopping the operation of the power converter 300 upon determining that the capacitor 302 is degraded, short-circuited, or open-circuited.

In some embodiments, the method 200 further comprises indicating that the capacitor 302 is degraded if the estimated ESR is greater than the initial ESR by at least 10% of the initial ESR.

In some embodiments, the method 200 further comprises indicating that the capacitor 302 is degraded if the estimated capacitance is less than the initial capacitance by at least 5% of the initial capacitance and at most 50% of the initial capacitance. In other words, the method 200 comprises indicating that the capacitor 302 is degraded if the estimated capacitance is less than the initial capacitance between 5% and 50% of the initial capacitance.

In some embodiments, the method 200 further comprises indicating that the capacitor 302 is short-circuited if the estimated ESR is less than the initial ESR by at least 100% of the initial ESR.

In some embodiments, the method 200 comprises indicating that the capacitor 302 is open-circuited if the estimated capacitance is less than the initial capacitance by at least 50% of the initial capacitance.

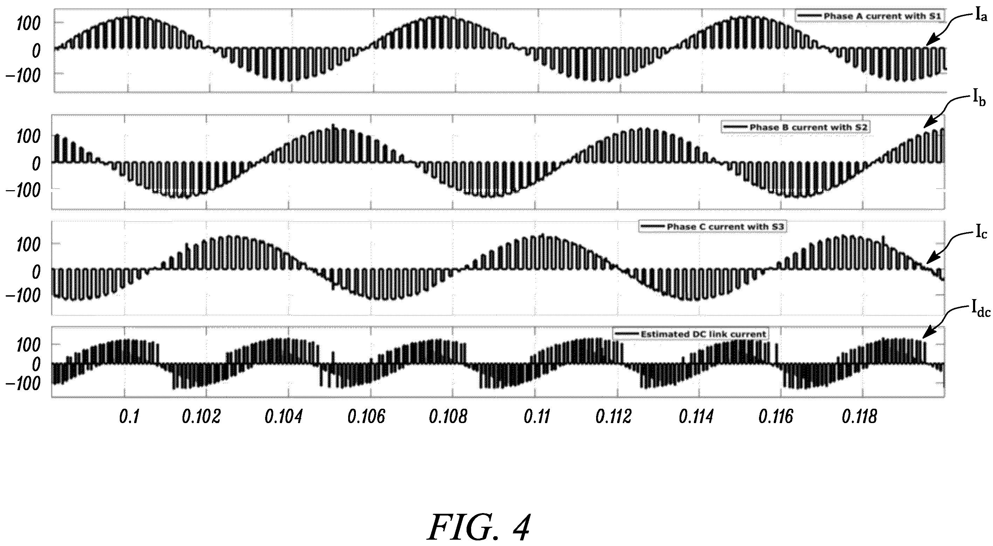

FIG. 4 shows an exemplary graphical representation of the current phases $I_a$, $I_b$, $I_c$. FIG. 4 further shows the DC link current $I_{dc}$ calculated based on the switching pulses SP1, SP2, SP3 (shown in FIG. 1) and the phase currents $I_a$, $I_b$, $I_c$.

FIG. 5 shows an exemplary graphical representation of the input current $I_{in}$ and the DC link current $I_{dc}$ (also shown in FIG. 4). FIG. 5 further shows the capacitor current $I_{cap}$ calculated based on the DC link current $I_{dc}$ and the input current $I_{in}$.

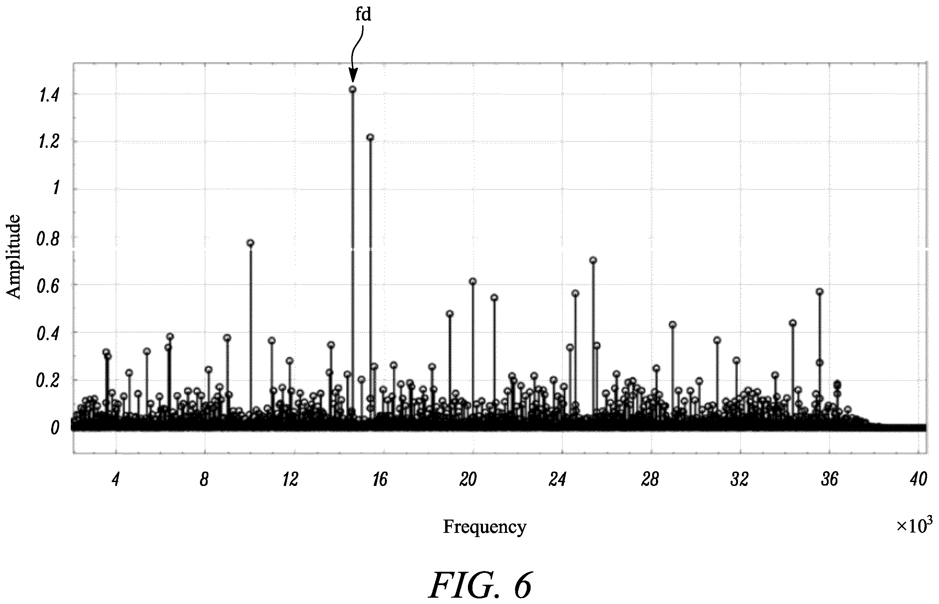

FIG. 6 shows an exemplary graph depicting an amplitude versus a frequency of the DC link capacitor voltage $V_{dc}$ shown in FIG. 1. FIG. 6 further shows the dominant frequency component fd of the DC link capacitor voltage $V_{dc}$.

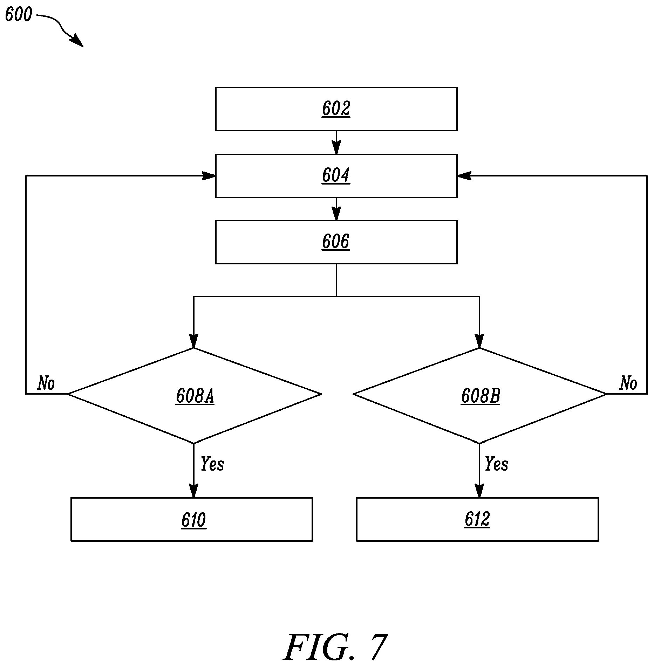

FIG. 7 shows a flow chart of a method 600 for determining the estimated ESR of the capacitor 302 shown in FIG. 1, according to an embodiment of the present disclosure. FIG. 7 is described with further reference to FIGS. 1-6.

The method 600 comprises a step 602 equivalent to the step 202 of the method 200. Specifically, at step 602, the method 600 comprises acquiring the DC link capacitor voltage $V_{dc}$, the input current $I_{in}$, the phase currents $I_a$, $I_b$, $I_c$, and the switching pulses SP1, SP2, SP3 of the power converter 300.

The method 600 further comprises a step 604 equivalent to the step 208 of the method 200. Specifically, at step 604, the method 600 comprises applying the Goertzel algorithm to determine the first z-domain equation $H(z)I_{cap}$ of the capacitor current $I_{cap}$ and the second z-domain equation $H(z)V_{dc}$ of the DC link capacitor voltage $V_{dc}$.

The method 600 further comprises a step 606 comprising determining the estimated ESR based on the first z-domain equation $H(z)I_{cap}$ of the capacitor current $I_{cap}$ and the second z-domain equation $H(z)V_{dc}$ of the DC link capacitor voltage $V_{dc}$.

The method 600 further comprises a step 608A comprising determining if the estimated ESR is greater than the initial ESR by at least 10% of the initial ESR. The method 600 proceeds to a step 610 comprising indicating that the capacitor 302 is degraded when the estimated ESR is greater than the initial ESR by at least 10% of the initial ESR, otherwise the method 600 proceeds to the step 604.

The method 600 further comprises a step 608B comprising determining if the estimated ESR is less than the initial ESR by at least 100% of the initial ESR. The method 600 proceeds to a step 612 comprising indicating that the capacitor 302 is short-circuited if the estimated ESR is less than the initial ESR by at least 100% of the initial ESR, otherwise the method 600 proceeds to the step 604.

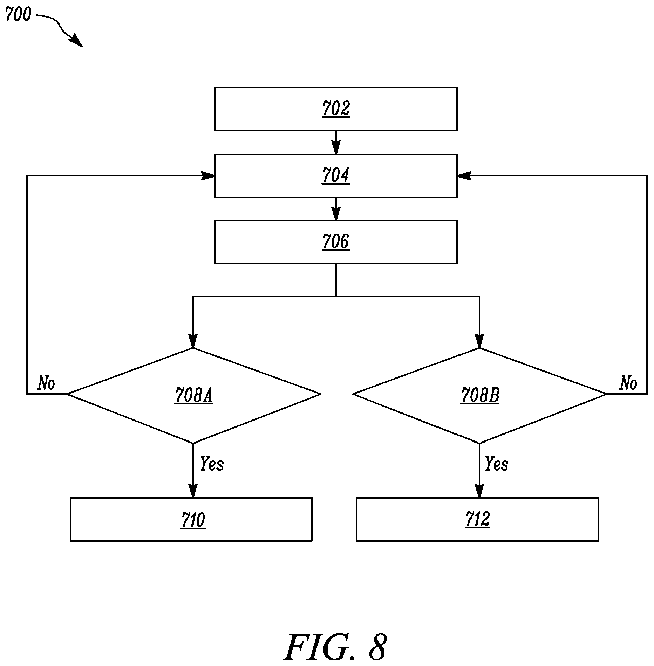

FIG. 8 shows a flow chart of a method 700 for determining the estimated capacitance of the capacitor 302 shown in FIG. 1, according to an embodiment of the present disclosure. FIG. 8 is described with further reference to FIGS. 1-6.

The method 700 comprises a step 702 equivalent to the step 202 of the method 200. Specifically, at step 702, the method 700 comprises acquiring the DC link capacitor voltage $V_{dc}$, the input current $I_{in}$, the phase currents $I_a$, $I_b$, $I_c$, and the switching pulses SP1, SP2, SP3 of the power converter 300.

The method 700 further comprises a step 704 equivalent to the step 208 of the method 200. Specifically, at step 704, the method 700 comprises applying the Goertzel algorithm to determine the first z-domain equation $H(z)I_{cap}$ of the capacitor current $I_{cap}$ and the second z-domain equation $H(z)V_{dc}$ of the DC link capacitor voltage $V_{dc}$.

The method 700 further comprises a step 706 comprising determining the estimated ESR based on the first z-domain equation $H(z)I_{cap}$ of the capacitor current $I_{cap}$ and the second z-domain equation $H(z)V_{dc}$ of the DC link capacitor voltage $V_{dc}$.

The method 700 further comprises a step 708A comprising determining if the estimated capacitance is less than the initial capacitance by at least 5% of the initial capacitance and at most 50% of the initial capacitance. The method 700 proceeds to a step 710 comprising indicating that the capacitor 302 is degraded when the estimated capacitance is less than the initial capacitance by at least 5% of the initial capacitance and at most 50% of the initial capacitance, otherwise the method 700 proceeds to the step 704.

The method 700 further comprises a step 708B comprising determining if the estimated capacitance is less than the initial capacitance by at least 50% of the initial capacitance. The method 700 proceeds to a step 712 comprising indicating that the capacitor 302 is open-circuited if the estimated capacitance is less than the initial capacitance by at least 50% of the initial capacitance, otherwise the method 700 proceeds to the step 704.

Referring to FIGS. 1 to 8, the method 200 may enable equipment health monitoring (EHM) and remaining useful life estimation of the capacitor 302 in the power converter 300. The method 200 may be applied to existing power converters just by accessing terminals that are usually available for a user by acquiring the DC link capacitor voltage $V_{dc}$, the input current $I_{in}$, the phase currents $I_a$, $I_b$, $I_c$, and the switching pulses SP1, SP2, SP3 of the power converter 300. These parameters may be easy to obtain using available data and using inexpensive sensors and may not require any customized circuits to extract any signature. Therefore, the method 200 may be easily applied to any commercial off-the-shelf as well as in-house power converter systems. The method 200 may further provide an early detection of degradation, short-circuits, or open-circuits, which further may enable to prevent the power converter failures. The method 200 may therefore reduce maintenance costs. Further, the method 200 uses the estimated capacitance and the estimated ESR and therefore may be applied to dominant capacitor technologies.

List of reference signs (part of the description)

| | |
|---|---|
| 100 | System |
| 102 | Processor |
| 104 | Memory |
| 200 | Method |
| 202 | Step |
| 204 | Step |
| 206 | Step |
| 208 | Step |
| 210 | Step |
| 212 | Step |
| 214 | Step |
| 300 | Power Converter |
| 302 | Capacitor |
| 304 | Voltage Sensor |
| 306 | Input Current Sensor |
| 308 | Phase Current Sensors |
| 320 | DC source |
| 330 | Load |
| 340 | Controller |
| 600 | Method |
| 602 | Step |
| 604 | Step |
| 606 | Step |
| 608A | Step |
| 608B | Step |
| 610 | Step |

| 612 | Step |
|---|---|
| 700 | Method |
| 702 | Step |
| 704 | Step |
| 706 | Step |
| 708A | Step |
| 708B | Step |
| 710 | Step |
| 712 | Step |
| fd | Dominant Frequency Component |
| $V_{dc}$ | DC Link Capacitor Voltage |
| $I_{dc}$ | DC Link Current |
| $I_{cap}$ | Capacitor Current |
| $I_{in}$ | Input Current |
| $I_a$ | Phase Current |
| $I_b$ | Phase Current |
| $I_c$ | Phase Current |
| S1 | Switch |
| S2 | Switch |
| S3 | Switch |
| S4 | Switch |
| S5 | Switch |
| S6 | Switch |
| SP1 | Switching Pulses |
| SP2 | Switching Pulses |
| SP3 | Switching Pulses |

**Claims**

1. A method (200) for monitoring a health of a capacitor (302) of a power converter (300), the method (200) comprising the steps of:

   acquiring a DC link capacitor voltage ($V_{dc}$), wherein the method is **characterised by** comprising further the steps of acquiring an input current ($I_{in}$), phase currents ($I_a$, $I_b$, $I_c$), and switching pulses (SP1, SP2, SP3) of the power converter (300);
   calculating a DC link current ($I_{dc}$) based on the switching pulses (SP1, SP2, SP3) and the phase currents ($I_a$, $I_b$, $I_c$);
   calculating a capacitor current ($I_{cap}$) based on the DC link current ($I_{dc}$) and the input current ($I_{in}$);
   applying Goertzel algorithm to determine a first z-domain equation (H(z)Icap) of the capacitor current ($I_{cap}$) and a second z-domain equation (H(z)Vdc) of the DC link capacitor voltage ($V_{dc}$);
   determining an estimated Equivalent Series Resistance (ESR) and an estimated capacitance of the capacitor (302) based on the first z-domain equation (H(z)$I_{cap}$) of the capacitor current ($I_{cap}$) and the second z-domain equation (H(z)$V_{dc}$) of the DC link capacitor voltage ($V_{dc}$);
   retrieving an initial ESR and an initial capacitance of the capacitor (302); and
   comparing the estimated ESR with the initial ESR and/or the estimated capacitance with the initial capacitance to determine if the capacitor (302) is degraded, short-circuited, or open-circuited.

2. The method (200) of claim 1, comprising pausing an operation of the power converter (300) upon determining that the capacitor (302) is degraded, short-circuited, or open-circuited.

3. The method (200) of claim 1 or 2, wherein the DC link capacitor voltage ($V_{dc}$) is acquired from a voltage sensor (304), and/or the input current ($I_{in}$) is acquired from an input current sensor (306).

4. The method (200) of any preceding claim, wherein the phase currents ($I_a$, $I_b$, $I_c$) are acquired from corresponding phase current sensors (308).

5. The method (200) of any preceding claim, wherein the switching pulses (SP1, SP2. SP3) are acquired from a controller (340) of the power converter (300).

6. The method (200) of any preceding claim, wherein the DC link current ($I_{dc}$) is calculated from the equation:

$$I_{dc} = SP1 * I_a + SP2 * I_b + SP3 * I_c$$

7. The method (200) of any preceding claim, wherein the capacitor current ($I_{cap}$) is calculated by subtracting the DC link current ($I_{dc}$) from the input current ($I_{in}$).

8. The method (200) of any preceding claim, wherein the first z-domain equation ($H(z)I_{cap}$) of the capacitor current ($I_{cap}$) is:

$$H(z)Icap = \frac{1 - w^{kx}NxZ^{-1}}{1 - 2\cos\left(\frac{2\pi kx}{Nx}\right)Z^{-1} + Z^{-2}} * Icap$$

where, Nx is a number of samples and Kx is:

$$Kx = \frac{Nx}{1/_{Nx*Ts}}$$

where, Ts is a sampling time.

9. The method (200) of any preceding claim, wherein the second z-domain equation ($H(z)V_{dc}$) of the DC link capacitor voltage ($V_{dc}$) is:

$$H(z)Vdc = \frac{1 - w^{kx}NxZ^{-1}}{1 - 2\cos\left(\frac{2\pi kx}{Nx}\right)Z^{-1} + Z^{-2}} * Vdc$$

where, Nx is the number of samples and kx is,

$$Kx = \frac{Nx}{1/_{Nx*Ts}}$$

where, Ts is the sampling time.

10. The method (200) of any preceding claim, wherein the estimated ESR of the capacitor (302) is estimated from the equation:

$$estimated\ ESR = Real(\frac{H(z)Vdc}{H(z)Icap})$$

11. The method (200) of any preceding claim, comprising identifying a dominant frequency component (fd) based on the DC link capacitor voltage ($V_{dc}$).

12. The method (200) of claim 11, wherein the estimated capacitance of the capacitor (302) is estimated from the equation:

$$estimated\ capacitance = Imag\left(\frac{H(z)Vdc}{H(z)Icap}\right) * abs(1/(2 * pi * fd))$$

13. The method (200) of any preceding claim, further comprising indicating that the capacitor (302) is degraded if the estimated ESR is greater than the initial ESR by at least 10% of the initial ESR, and/or further comprising indicating that the capacitor (302) is short-circuited if the estimated ESR is less than the initial ESR by at least 100% of the initial ESR.

14. The method (200) of any preceding claim, further comprising indicating that the capacitor (302) is degraded if the estimated capacitance is less than the initial capacitance by at least 5% of the initial capacitance and at most 50% of the initial capacitance, and/or further comprising indicating that the capacitor (302) is open-circuited if the estimated capacitance is less than the initial capacitance by at least 50% of the initial capacitance.

15. A system (100) including a processor (102) and a memory (104) having stored therein a plurality of instructions that when executed by the processor (102) causes the system (100) to perform the method (200) of any of the preceding claims.

**Patentansprüche**

1. Verfahren (200) zum Überwachen eines Zustands eines Kondensators (302) eines Stromwandlers (300), wobei das Verfahren (200) die folgenden Schritte umfasst:

Erfassen einer Zwischenkreiskondensatorspannung ($V_{dc}$), wobei das Verfahren **dadurch gekennzeichnet ist, dass** es ferner die Schritte des Erfassens eines Eingangsstroms ($I_{in}$), von Phasenströmen ($I_a$, $I_b$, $I_c$) und von Schaltimpulsen (SP1, SP2, SP3) des Stromwandlers (300) umfasst;
Berechnen eines Zwischenkreisstroms ($I_{dc}$) basierend auf den Schaltimpulsen (SP1, SP2, SP3) und den Phasenströmen ($I_a$, $I_b$, $I_c$),
Berechnen eines Kondensatorstroms ($I_{cap}$) basierend auf dem Zwischenkreisstrom ($I_{dc}$) und dem Eingangs-strom ($I_{in}$);
Anwenden des Goertzel-Algorithmus, um eine erste z-Domänengleichung (H(z)Icap) des Kondensatorstroms ($I_{cap}$) und eine zweite z-Domänengleichung (H(z)Vdc) der Zwischenkreiskondensatorspannung ($V_{dc}$) zu bestimmen;
Bestimmen eines geschätzten Äquivalenten Serienwiderstands (ESR) und einer geschätzten Kapazität des Kondensators (302) basierend auf der ersten z-Domänengleichung (H(z)$I_{cap}$) des Kondensatorstroms ($I_{cap}$) und der zweiten z-Domänengleichung (H(z)$V_{dc}$) der Zwischenkreiskondensatorspannung ($V_{dc}$),
Abrufen eines anfänglichen ESR und einer Anfangskapazität des Kondensators (302); und
Vergleichen des geschätzten ESR mit dem anfänglichen ESR und/oder der geschätzten Kapazität mit der Anfangskapazität, um zu bestimmen, ob der Kondensator (302) sich verschlechtert hat, kurzgeschlossen oder offen ist.

2. Verfahren (200) nach Anspruch 1, umfassend das Anhalten eines Betriebs des Stromwandlers (300), wenn bestimmt wird, dass der Kondensator (302) sich verschlechtert hat, kurzgeschlossen oder offen ist.

3. Verfahren (200) nach Anspruch 1 oder 2, wobei die Zwischenkreiskondensatorspannung ($V_{dc}$) von einem Spannungssensor (304) erfasst wird und/oder der Eingangsstrom ($I_{in}$) von einem Eingangsstromsensor (306) erfasst wird.

4. Verfahren (200) nach einem vorhergehenden Anspruch, wobei die Phasenströme ($I_a$, $I_b$, $I_c$) von entsprechenden Phasenstromsensoren (308) erfasst werden.

5. Verfahren (200) nach einem vorhergehenden Anspruch, wobei die Schaltimpulse (SP1, SP2, SP3) von einem Steuergerät (340) des Stromwandlers (300) erfasst werden.

6. Verfahren (200) nach einem vorhergehenden Anspruch, wobei der Zwischenkreisstrom ($I_{dc}$) aus der folgenden Gleichung berechnet wird:

$$I_{dc} = SP1 * I_a + SP2 * I_b + SP3 * I_c$$
.

7. Verfahren (200) nach einem vorhergehenden Anspruch, wobei der Kondensatorstrom ($I_{cap}$) durch Subtrahieren des Zwischenkreisstroms ($I_{dc}$) von dem Eingangsstrom ($I_{in}$) berechnet wird.

8. Verfahren (200) nach einem vorhergehenden Anspruch, wobei die erste z-Domänengleichung (H(z)$I_{cap}$) des Kondensatorstroms ($I_{cap}$) wie folgt ist:

$$H(z)Icap = \frac{1 - w^{kx}NxZ^{-1}}{1 - 2\cos\left(\frac{2\pi kx}{Nx}\right)Z^{-1} + Z^{-2}} * Icap$$
,

wobei Nx eine Anzahl an Proben ist und Kx wie folgt ist:

$$Kx = \frac{Nx}{1/_{Nx*Ts}}$$
,

wobei Ts eine Abtastzeit ist.

9. Verfahren (200) nach einem vorhergehenden Anspruch, wobei die zweite z-Domänengleichung ($H(z)V_{dc}$) der Zwischenkreiskondensatorspannung ($V_{dc}$) wie folgt ist:

$$H(z)Vdc = \frac{1 - w^{kx}NxZ^{-1}}{1 - 2\cos\left(\frac{2\pi kx}{Nx}\right)Z^{-1} + Z^{-2}} * Vdc$$

, wobei Nx die Anzahl an Proben ist und kx wie folgt ist

$$Kx = \frac{Nx}{1/_{Nx*Ts}}$$
,

wobei Ts die Abtastzeit ist.

10. Verfahren (200) nach einem vorhergehenden Anspruch, wobei der geschätzte ESR des Kondensators (302) aus der folgenden Gleichung geschätzt wird:

$$\text{geschätzter ESR} = \text{Real}\left(\frac{H(z)Vdc}{H(z)Icap}\right).$$

11. Verfahren (200) nach einem vorhergehenden Anspruch, umfassend das Identifizieren einer dominanten Frequenzkomponente (fd) basierend auf der Zwischenkreiskondensatorspannung ($Vd_c$).

12. Verfahren (200) nach Anspruch 11, wobei die geschätzte Kapazität des Kondensators (302) aus der folgenden Gleichung geschätzt wird:

$$\text{geschätzte Kapazität} = \text{Imag}\left(\frac{H(z)Vdc}{H(z)Icap}\right) * abs(1/(2 * pi * fd)).$$

13. Verfahren (200) nach einem vorhergehenden Anspruch, ferner umfassend das Angeben, dass der Kondensator (302) sich verschlechtert hat, wenn der geschätzte ESR um mindestens 10 % des anfänglichen ESR größer als der anfängliche ESR ist, und/oder ferner umfassend das Angeben, dass der Kondensator (302) kurzgeschlossen ist, wenn der geschätzte ESR um mindestens 100 % des anfänglichen ESR kleiner als der anfängliche ESR ist.

14. Verfahren (200) nach einem vorhergehenden Anspruch, ferner umfassend das Angeben, dass der Kondensator (302) sich verschlechtert hat, wenn die geschätzte Kapazität um mindestens 5 % der Anfangskapazität und höchstens 50 % der Anfangskapazität kleiner als die Anfangskapazität ist, und/oder ferner umfassend das Angeben, dass der Kondensator (302) offen ist, wenn die geschätzte Kapazität um mindestens 50 % der Anfangskapazität kleiner als die Anfangskapazität ist.

**15.** System (100), beinhaltend einen Prozessor (102) und einen Speicher (104) mit einer Vielzahl von darin gespeicherten Anweisungen, die, wenn sie durch den Prozessor (102) ausgeführt werden, das System (100) dazu veranlassen, das Verfahren (200) nach einem der vorhergehenden Ansprüche durchzuführen.

## Revendications

**1.** Procédé (200) permettant la surveillance de l'état d'un condensateur (302) d'un convertisseur de puissance (300), le procédé (200) comprenant les étapes de :

acquisition d'une tension de condensateur de liaison CC ($V_{dc}$), dans lequel le procédé est **caractérisé en ce qu'**il comprend en outre les étapes d'acquisition d'un courant d'entrée ($I_{in}$), de courants de phase ($I_a$, $I_b$, $I_c$) et d'impulsions de commutation (SP1, SP2, SP3) du convertisseur de puissance (300) ;
calcul d'un courant de liaison CC ($I_{dc}$) sur la base des impulsions de commutation (SP1, SP2, SP3) et des courants de phase ($I_a$, $I_b$, $I_c$) ;
calcul d'un courant de condensateur ($I_{cap}$) sur la base du courant de liaison CC ($I_{dc}$) et du courant d'entrée ($I_{in}$) ;
application de l'algorithme de Goertzel pour déterminer une première équation de domaine z (H(z)Icap) du courant de condensateur ($I_{cap}$) et une deuxième équation de domaine z (H(z)Vdc) de la tension de condensateur de liaison CC ($V_{dc}$) ;
détermination d'une résistance série équivalente (ESR) estimée et d'une capacité estimée du condensateur (302) sur la base de la première équation du domaine z (H(z)$I_{cap}$) du courant de condensateur ($I_{cap}$) et de la seconde équation du domaine z (H(z)$V_{dc}$) de la tension de condensateur de liaison CC ($V_{dc}$) ;
récupération d'une ESR initiale et d'une capacité initiale du condensateur (302) ; et
comparaison de l'ESR estimée à l'ESR initiale et/ou de la capacité estimée à la capacité initiale pour déterminer si le condensateur (302) est dégradé, court-circuité ou en circuit ouvert.

**2.** Procédé (200) selon la revendication 1, comprenant la mise en pause d'un fonctionnement du convertisseur de puissance (300) lors de la détermination que le condensateur (302) est dégradé, court-circuité ou en circuit ouvert.

**3.** Procédé (200) selon la revendication 1 ou 2, dans lequel la tension de condensateur de liaison CC ($V_{dc}$) est acquise à partir d'un capteur de tension (304), et/ou le courant d'entrée ($I_{in}$) est acquis à partir d'un capteur de courant d'entrée (306).

**4.** Procédé (200) selon l'une quelconque des revendications précédentes, dans lequel les courants de phase ($I_a$, $I_b$, $I_c$) sont acquis à partir de capteurs de courant de phase correspondants (308).

**5.** Procédé (200) selon l'une quelconque des revendications précédentes, dans lequel les impulsions de commutation (SP1, SP2, SP3) sont acquises à partir d'un contrôleur (340) du convertisseur de puissance (300).

**6.** Procédé (200) selon l'une quelconque des revendications précédentes, dans lequel le courant de liaison CC ($I_{dc}$) est calculé à partir de l'équation :

$$I_{dc} = SP1 * I_a + SP2 * I_b + SP3 * I_c$$

**7.** Procédé (200) selon l'une quelconque des revendications précédentes, dans lequel le courant de condensateur ($I_{cap}$) est calculé en soustrayant le courant de liaison CC ($I_{dc}$) du courant d'entrée ($I_{in}$).

**8.** Procédé (200) selon l'une quelconque des revendications précédentes, dans lequel la première équation du domaine z (H(z)$I_{cap}$) du courant de condensateur ($I_{cap}$) est :

$$H(z)Icap = \frac{1 - w^{kx}NxZ^{-1}}{1 - 2\cos\left(\frac{2\pi kx}{Nx}\right)Z^{-1} + Z^{-2}} * Icap$$

où, Nx est un nombre d'échantillons et Kx est :

$$Kx = \frac{Nx}{1/_{Nx*Ts}}$$

où, Ts est un temps d'échantillonnage.

**9.** Procédé (200) selon l'une quelconque des revendications précédentes, dans lequel la deuxième équation du domaine z (H(z)V$_{dc}$) de la tension de condensateur de liaison CC (V$_{dc}$) est :

$$H(z)Vdc = \frac{1 - w^{kx}NxZ^{-1}}{1 - 2\cos\left(\frac{2\pi kx}{Nx}\right)Z^{-1} + Z^{-2}} * Vdc$$

où, Nx est le nombre d'échantillons et kx est,

$$Kx = \frac{Nx}{1/_{Nx*Ts}}$$

où, Ts est le temps d'échantillonnage.

**10.** Procédé (200) selon l'une quelconque des revendications précédentes, dans lequel l'ESR estimée du condensateur (302) est estimée à partir de l'équation :

$$ESR\ estimée = (\frac{H(z)Vdc}{H(z)Icap})$$

réelle.

**11.** Procédé (200) selon l'une quelconque des revendications précédentes, comprenant l'identification d'une composante de fréquence dominante (fd) sur la base de la tension de condensateur de liaison CC (V$_{dc}$).

**12.** Procédé (200) selon la revendication 11, dans lequel la capacité estimée du condensateur (302) est estimée à partir de l'équation :

$$capacité\ estimée = \frac{Imag\ (\frac{H(z)Vdc}{H(z)Icap}) * abs(1/(2 * pi * fd))}{}$$ .

**13.** Procédé (200) selon l'une quelconque des revendications précédentes, comprenant en outre l'indication que le condensateur (302) est dégradé si l'ESR estimée est supérieure à l'ESR initiale d'au moins 10 % de l'ESR initiale, et/ou comprenant en outre l'indication que le condensateur (302) est court-circuité si l'ESR estimée est inférieure à l'ESR initiale d'au moins 100 % de l'ESR initiale.

**14.** Procédé (200) selon l'une quelconque des revendications précédentes, comprenant en outre l'indication que le condensateur (302) est dégradé si la capacité estimée est inférieure à la capacité initiale d'au moins 5 % de la capacité initiale et d'au plus 50 % de la capacité initiale, et/ou comprenant en outre l'indication que le condensateur (302) est en circuit ouvert si la capacité estimée est inférieure à la capacité initiale d'au moins 50 % de la capacité initiale.

**15.** Système (100) comprenant un processeur (102) et une mémoire (104) dans laquelle sont stockées une pluralité d'instructions qui, lorsqu'elles sont exécutées par le processeur (102), amènent le système (100) à réaliser le procédé (200) selon l'une quelconque des revendications précédentes.

*FIG. 1*

*FIG. 2*

```
┌─────────────────────────────────────────────────────────────────────────────┐
│ ACQUIRE DC LINK CAPACITOR VOLTAGE (V_dc), INPUT CURRENT (I_in), PHASE          │  202
│ CURRENTS (I_a, I_b, I_c), AND SWITCHING PULSES (SP1, SP2, SP3) OF POWER        │
│ CONVERTER                                                                     │
└─────────────────────────────────────────────────────────────────────────────┘
                                    │
                                    ▼
┌─────────────────────────────────────────────────────────────────────────────┐
│ CALCULATE DC LINK CURRENT (I_dc) BASED ON SWITCHING PULSES (SP1, SP2, SP3)     │  204
│ AND PHASE CURRENTS (I_a, I_b, I_c)                                             │
└─────────────────────────────────────────────────────────────────────────────┘
                                    │
                                    ▼
┌─────────────────────────────────────────────────────────────────────────────┐
│ CALCULATE CAPACITOR CURRENT (I_cap) BASED ON DC LINK CURRENT (I_dc) AND        │  206
│ INPUT CURRENT (I_in)                                                           │
└─────────────────────────────────────────────────────────────────────────────┘
                                    │
                                    ▼
┌─────────────────────────────────────────────────────────────────────────────┐
│ APPLY GOERTZEL ALGORITHM TO DETERMINE FIRST Z-DOMAIN EQUATION (H(z)I_cap) OF   │  208
│ CAPACITOR CURRENT (I_cap) AND SECOND Z-DOMAIN EQUATION (H(z)V_dc) OF DC LINK    │
│ CAPACITOR VOLTAGE (V_dc)                                                       │
└─────────────────────────────────────────────────────────────────────────────┘
                                    │
                                    ▼
┌─────────────────────────────────────────────────────────────────────────────┐
│ DETERMINE ESTIMATED EQUIVALENT SERIES RESISTANCE (ESR) AND ESTIMATED           │  210
│ CAPACITANCE OF CAPACITOR BASED ON FIRST Z-DOMAIN EQUATION (H(z)I_cap) OF        │
│ CAPACITOR CURRENT (I_cap) AND SECOND Z-DOMAIN EQUATION (H(z)V_dc) OF DC LINK    │
│ CAPACITOR VOLTAGE (V_dc)                                                       │
└─────────────────────────────────────────────────────────────────────────────┘
                                    │
                                    ▼
┌─────────────────────────────────────────────────────────────────────────────┐
│ RETRIEVE INITIAL ESR AND INITIAL CAPACITANCE OF CAPACITOR                      │  212
└─────────────────────────────────────────────────────────────────────────────┘
                                    │
                                    ▼
┌─────────────────────────────────────────────────────────────────────────────┐
│ COMPARE ESTIMATED ESR WITH INITIAL ESR AND/OR ESTIMATED CAPACITANCE WITH       │  214
│ INITIAL CAPACITANCE TO DETERMINE IF CAPACITOR IS DEGRADED, SHORT-CIRCUITED,     │
│ OR OPEN-CIRCUITED                                                              │
└─────────────────────────────────────────────────────────────────────────────┘
```

200

*FIG. 3*

*FIG. 4*

*FIG. 5*

EP 4 636 426 B1

*FIG. 6*

EP 4 636 426 B1

600

```
        ┌─────────────────┐
        │       602       │
        └─────────────────┘
                 │
                 ▼
  ┌──────────────────────────────┐
  │             604              │◄──────────┐
  └──────────────────────────────┘          │
                 │                           │
                 ▼                           │
        ┌─────────────────┐                  │
        │       606       │                  │
        └─────────────────┘                  │
                 │                           │
        ┌────────┴────────┐                  │
        ▼                 ▼                  │
      ◇608A◇            ◇608B◇               │
   No            No                          │
        │                 │
       Yes               Yes
        ▼                 ▼
   ┌────────┐         ┌────────┐
   │  610   │         │  612   │
   └────────┘         └────────┘
```

*FIG. 7*

*FIG. 8*

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Condition Monitoring of DC-Link Capacitors Using Goertzel Algorithm for Failure Precursor Parameter and Temperature Estimation. **SUNDARARAJAN PRASANTH et al.** IEEE TRANSACTIONS ON POWER ELECTRONICS. INSTITUTE OF ELECTRICAL AND ELECTRONICS ENGINEERS, June 2020, vol. 35, 6386-6396